# EUROPÄISCHE PATENTANMELDUNG

(11) **EP 3 370 490 A1**
(43) Veröffentlichungstag der Anmeldung: **05.09.2018**
(21) Anmeldenummer: 17158746.2
(22) Anmeldetag: 01.03.2017
(51) Int. Cl.: H05K 7/20

(54) **KÜHLSYSTEM FÜR DEN FUNKTIONSERHALT DER ELEKTRO- UND ELEKTRONIKKOMPONENTEN IN EINEM SCHALTSCHRANK**

(71) Anmelder: Swibox AG, 3175 Flamatt (CH)
(72) Erfinder: Schaffitz, Matthias, 3178 Bösingen (CH); Nydegger, Andreas, 3150 Schwarzenburg (CH); Bracher, Christian, 3363 Oberönz (CH)
(74) Vertreter: Gachnang, Hans Rudolf

(57) **Zusammenfassung**

Die Erfindung betrifft ein Kühlsystem (5) für den Funktionserhalt der Elektro- und Elektronikkomponenten in einem Schaltschrank (1) bei einem Brandfall in einem Gebäude und/oder bei Überhitzung der Elektronik- und Elektroelemente durch Verlustleistung im Innern des Schaltschranks (1). Mit einem flüssigen Kühlmedium (13) das in einem Behälter (11), der mit dem Innern des Schaltschranks (1) verbunden ist, kann eine Notkühlung im Innern des Schaltschranks (1) aufgebaut und dadurch der Funktionsausfall der darin angeordneten Komponenten über lange Zeit verhindert werden.

## Beschreibung

Gegenstand der Erfindung ist ein Kühlsystem für den Funktionserhalt der Elektro- und Elektronikkomponenten in einem Schaltschrank gemäss Oberbegriff des Patentanspruchs 1.

Schaltschränke mit Feuerwiderstand für die Steuerung von Infrastrukturanlagen in öffentlichen Gebäuden wie Industrien, Flughäfen, Spitäler, Geschäftshäuser aber auch Tunnel sind bekannt. Die darin untergebrachte Elektronik-und Elektrokomponenten stellen einen einwandfreien Betrieb nicht nur von Infrastrukturanlagen, sondern auch von medizinischen Geräten in Spitälern, Computeranlagen, Maschinen in Fabriken, resp. in Tunnelanlagen Fluchtwegsignalisationen, Lüftungs- und Rauchabsauganlagen, sicher. Bei Ausbruch eines Brandes in der Umgebung des Schaltschrankes, besteht die latente Gefahr, dass innerhalb kürzester Zeit die Elektro- und Elektronikkomponenten infolge Überhitzung ihren Dienst versagen und folglich lebenswichtige Funktionen für den Betrieb, zum Beispiel eines Spitals oder auch der Lüftungsanlagen in grossen Gebäuden oder Tunnelanlagen ausfallen. Grössere Schaltschränke sind mit Kühlanlagen ausgestattet oder mit einem zentralen Kühlsystem verbunden, die die bei normalen Betrieb entstehende als Wärme anfallende Verlustenergie aus dem mit Brandschutzplatten isolierten Schaltschrank abführen. Elektrisch betriebene Kühlanlagen haben immer eine Verbindung zur Umgebung ausserhalb des Schaltschrankes, um die Wärme aus dem Inneren des Schaltschranks abzuführen. Bei einem Brand muss nun diese Wärmebrücke umgehend geschlossen, die Kühlanlage von Schaltschrank entkoppelt und ausser Betrieb genommen werden. Bei Wegfall der Kühlung steigt in der Folge die Temperatur im komplett wärmeisolierten Schaltschrank mit Feuerwiderstand durch die Abwärme der Komponenten innert kurzer Zeit soweit an, dass die gesamte Elektronik bzw. Elektrotechnik der Infrastruktur ausfällt und zwingend notwendige Anlagen in einem Betrieb, sei es nun in einem Spital, einem Fabrikationsbetrieb oder in einem Tunnel lahmgelegt wird.

Eine Aufgabe der vorliegenden Erfindung besteht nun darin, ein unabhängiges Kühlsystem zu schaffen das sicherstellt, dass die Elektro- und Elektronikkomponenten im Schaltschrank über eine je nach Brandschutzklasse vordefinierte Zeit vor Überhitzung geschützt sind und damit die Funktion der von den Komponenten im Schaltschrank gesteuerten Aggregate aufrecht zu erhalten.

Gelöst wird die Aufgabe durch ein Kühlsystem mit den Merkmalen des Patentanspruches 1. Vorteilhafte Ausgestaltung des Kühlsystems sind in den abhängigen Ansprüchen umschrieben.

Es gelingt mit dem erfindungsgemässen Kühlsystem, welches vollständig innerhalb oder am Schrank angebaut ist, die Funktionsfähigkeit eines Schaltschranks trotz Unterbruch der externen Kühlung über eine vorgebbare Zeit und unabhängig von einer externen Energiequelle aufrechtzuerhalten. Das anfänglich flüssige und nach dem Expandieren gasförmige Kühlmittel kann entweder über Kühlrippen die Kühlung vornehmen. Ein Tank, der das Kühlmittel enthält, kann für den nachträglichen Einbau der neuen Kühlung an einem Schaltschrank ausserhalb des Schaltschranks angeordnet sein und muss nicht zwangsläufig isoliert werden. In einer bevorzugten Ausführung wird auch der ausserhalb des Schaltschranks angeordnete Tank mit den Kühlmitteln isoliert. In einer weiteren vorteilhaften Ausbildung der Erfindung bei Neuanlagen werden der Kühlmitteltank und ein Wärmetauscher in einem an den Schaltschrank angebauten und mit diesem in Verbindung stehenden brandgeschützten Bereich angeordnet. Bei dieser Ausführungsform sind im eigentlichen Schaltschrankbereich keine Kühl- oder Wärmetauscher angeordnet. Die in den Schaltschrank eingebrachte Kühlmittelmenge aus dem Tank kann auf einfache Art und Weise durch ein Ventil erfolgen, welches in Abhängigkeit von der Temperatur innerhalb des Schaltschrankes regelt. Dies bedeutet, dass bei geringem Temperaturanstieg zu Beginn eines Brandes nur gerade die notwendige Kühlmenge eingebracht wird und erst bei zunehmender schädlicher Erwärmung des Schaltschranks durch die externe Temperaturerhöhung im Raum ausserhalb des Schaltschranks auch die Kühlmenge erhöht werden kann. Damit wird erreicht, dass über einen längeren Zeitraum die interne Kühlung unabhängig von der externen, die infolge eines Brands ausgefallen ist, aufrechterhalten werden kann.

Anhand eines illustrierten Ausführungsbeispiels wird die Erfindung näher erläutert. Es zeigen:
- Figur 1: eine schematische Darstellung eines Schaltschrankes mit bekannter externer Kühlung und einer erfindungsgemässen internen Notfallkühlung,
- Figur 2: eine schematische Darstellung eines Schaltschrankes mit einer seitlich am Schaltschrank angeordneten Schrankkühlung und einer internen Notfallkühlung
- Figur 3: eine schematische Darstellung eines Schaltschrankes mit einer externen Kühlung und einer Notfallkühlung, welche seitlich ausserhalb des Schaltschranks angeordnet ist.

Mit Bezugszeichen 1 ist ein Schaltschrank bezeichnet. Im Schaltschrank 1 sind, nicht dargestellt, elektronische und elektrische Komponenten untergebracht, welche zur Steuerung von Maschinen oder der Infrastruktur in Gebäuden wie Fabriken, Spitäler oder auch in Tunnelanlagen eingesetzt werden. Der Schaltschrank 1 ist im beschriebenen Beispiel von einer effizienten und brandresistenten Isolation 3 mit einem Isolationsmantel umgeben. Dieser schützt die Komponenten im Schaltschrank 1 im Brandfall gegen das externe Feuer und bis zu einem gewissen Mass gegen Temperatureinflüsse aus der Umgebung. Zur Kühlung der Verlustleistung der elektrischen und elektronischen Komponenten im Schaltschrank 1 steht dieser in Verbindung mit einem extern angeordneten Kühlaggregat 5. Das Kühlaggregat 5 kann Teil einer Klimaanlage für das Gebäude oder andere Anlagen sein. Das Kühlaggregat 5 ist mit Verbindungsleitungen 7, welche im Brandfall durch Brandschutzklappen 2 verschlossen werden, mit dem Innern des Schaltschrankes 1 verbunden. Diese Anordnung stellt den Stand der Technik dar.

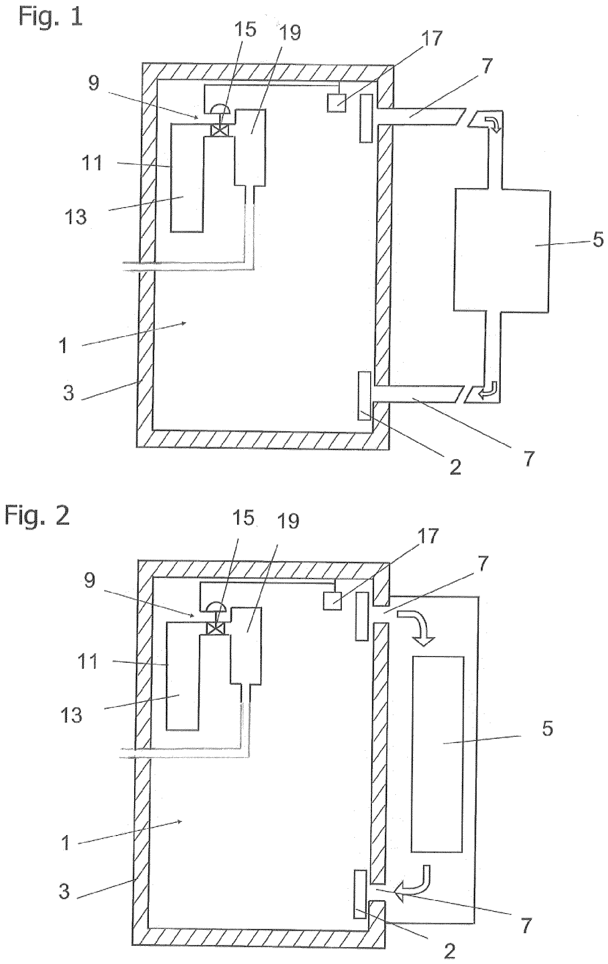

Zusätzlich zur externen Kühlanlage ist in Figur 1 im isolierten Schaltschrank 1 ein Notfall-Kühlsystem 9 schematisch dargestellt. Das Kühlsystem 9 umfasst einen Behälter 11, vorzugsweise einen Druckbehälter mit einem Kühlmedium 13, beispielsweise CO₂, in gasförmiger oder flüssiger Phase. Das Innere des Behälters 11 ist über eine Verbindungsleitung via ein Magnetventil 15 mit einem Wärmetauscher-System 19 aus Rohrbündeln, Platten oder einem Schichtwärmetauscher verbunden. Da es sich beim Kühlmedium um ein leicht flüchtiges Gas handelt, welches beim Phasenübergang flüssig/gasförmig entspannt, erfolgt kurzfristig eine grosse Kühlwirkung. Da im Gegensatz zum Kühlaggregat 5, welches extern zum Schaltschrank 1 in Alleinstellung angeordnet und selbst nicht gegen Brand geschützt ist, ist jederzeit eine Notkühlung ohne externe Stromversorgung gewährleistet.

Vorteilhafterweise wird das Gas aus dem intern angeordneten Behälter 11 pulsierend abgegeben, um eine Vereisung der Zuleitung zum Wärmetauscher 19 zu verhindern. In einer besonders vorteilhaften Ausgestaltung der Erfindung, wird in einer Zwischenphase nach dem Behälter 11 vorerst das Gas in eine Feststoffphase, d.h. in Trockeneis überführt, um die nötige Kühlleistung aus dem Phasenübergang (der Sublimation) nutzen zu können, welche bei -78°C stattfindet. Das Innere des Schaltschranks 1 wird in der Folge über das Wärmetauschersystem im Umluftbetrieb wirksam gekühlt. In der Ausgestaltung der Erfindung gemäss Figur 2 werden für alle Teile mit gleichen Funktionen gleiche Bezeichnungen verwendet. Im Unterschied zu Ausführung gemäss Figur 1 ist das extern angeordnete Kühlaggregat 5 direkt seitlich am Schaltschrank 1 angebracht und ist nur für die Kühlung dieses einzigen Schaltschrankes 1 vorgesehen. Die Absaug- und Einblasöffnungen vom Kühlaggregat 5 werden im Brandfall durch Brandschutzklappen 2 verschlossen. Sobald diese verschlossen sind, übernimmt wie in Figur 1 das intern im Schaltschrank angebrachte Notfall-Kühlsystem 9 das Kühlen der Verlustleistung der elektrischen Bauteile.

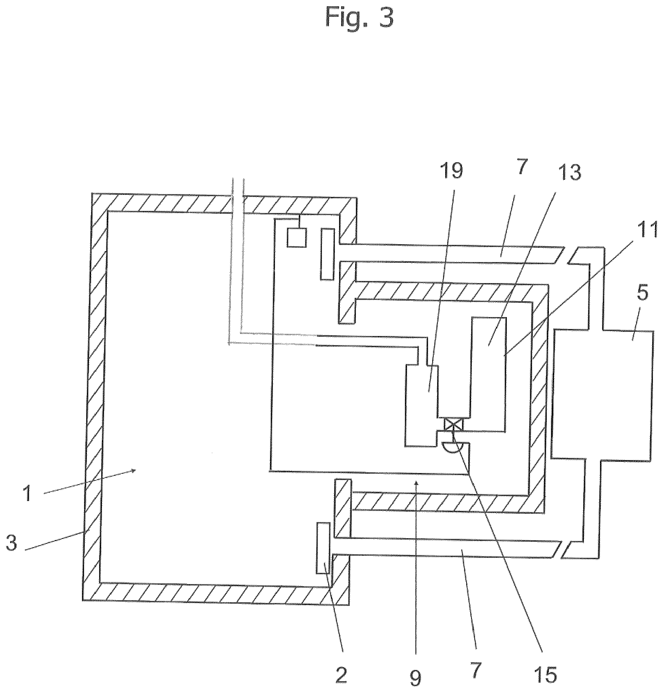

Figur 3 zeigt ein drittes Ausführungsbeispiel für den Neugerätebereich, bei dem nun das Notfall-Kühlsystem 9 seitlich am Schaltschrank 1 in einem mit brandresistenter Isolation 3 geschütztem Anbau untergebracht ist. Auch in dieser Anordnung wird das flüssige Kühlmedium 13 aus dem Behälter 11 in einem Zwischenschritt in die Feststoffphase Trocken überführt und dann über den Wärmetauscher 19 in den Elektroschrank 1 geleitet. Die Notkühlung kann folglich ohne externe Stromversorgung sichergestellt werden.

Nachfolgend wird die Funktionsweise der drei Ausführungsbeispiele näher erläutert. Bei einem Brandausbruch in einem Gebäude, in welchem der Schaltschrank 1 aufgestellt ist und dadurch beim Schaltschrank 1 rasch die Aussentemperatur ansteigt, werden ab einer bestimmten Temperatur im Innern des Schaltschranks 1 die Brandschutzklappen 2, mit welchem der Schaltschrank 1 mit der externen Kühlung 5 verbunden ist, geschlossen. In diesem Fall übernimmt nun das interne Notfall-Kühlsystem 9 die Aufgabe die Verlustleistung der im Schaltschrank 1 verbauten elektrischen und elektronischen Bauteile abzuführen, um damit eine Selbstzerstörung derjenigen zu verhindern. Durch Messung der Temperaturerhöhung im Innern des Schaltschrankes 1 mittels des im Schaltschrank 1 angebrachten Temperaturfühlers 17 wird über das Magnetventil 15 das Kühlmedium 13 unter Zwischenschaltung von bekannten Elementen zur Bildung von Trockenheit in den Wärmetauscher 19 geleitet, welcher die Temperatur im Schaltschrank 1 über eine gewisse Zeit regelt. Vorzugsweise wird das flüssige CO₂ pulsierend aus dem Behälter 11 abgegeben, um die Vereisung der Verbindungsleitungen zu vermeiden. In dieser Zeit, in welcher aus dem Behälter 11 das Kühlmedium über den Wärmetauscher 19 in den Schaltschrank 1 geleitet wird, bleiben die Funktionen der elektronischen und elektrischen Steuerungselemente im Schaltschrank aufrechterhalten. Das Aufrechterhalten der Kühlung ermöglicht mindestens temporär das Weiterbetreiben der Anlagen über eine vordefinierte Zeit von 30, 60, 90 oder sogar 120 Minuten.

Die Ausführung der Erfindung, wie sie zu Figur 1 beschrieben wird, erlaubt es bei genügend Platz, in einer bestehenden Anlage, also einem bestehenden Schaltschrank 1, nachträglich eine Notkühlung einzubauen. Auch die Ausführung in Figur 2 kann bei genügend Platz in eine bestehende Anlage nachgerüstet werden. Figur 3 eignet sich insbesondere bei Neuanlagen, wobei dort der Vorteil darin besteht, dass der Platz im Schaltschrank 1 vollumfänglich genutzt werden kann und das Notfall-Kühlsystem 19 beliebig gross und damit beliebig leistungsfähig gebaut werden kann.

## Patentansprüche

1. Kühlsystem für den Funktionserhalt der Elektro- und Elektronikkomponenten in einem brandresistent isolierten Schaltschrank (1) während eines Brandfalls und/oder bei Überhitzung des Innenbereichs des Schaltschranks (1) durch Verlustwärme der Elektro-oder Elektronikkomponenten, umfassend eine Verbindung zu einer externen Kühlvorrichtung (5) zum Kühlen des Innenraums des Schaltschranks (1) während des regulären Betriebs und einen Sensor (17) zur Erfassung der Innenraumtemperatur im Schaltschrank (1),
**dadurch gekennzeichnet, dass**
der Schaltschrank (1) eine unabhängig von einer externen Kühlung arbeitende Kühlvorrichtung (5) umfasst, welche im Brandfall bei Überschreiten einer vorgebbaren Innentemperatur selbsttätig die Kühlung aufnimmt.

2. Kühlsystem nach Anspruch 1, **dadurch gekennzeichnet, dass** die Kühlvorrichtung einen Kühlmittel enthaltenden Behälter (11) umfasst, aus welchem durch ein Ventil (15), gesteuert vom Sensor (17), Kühlmedium einem Wärmetauscher (19) im Innern des Schaltschranks zuführt.

3. Kühlsystem nach Anspruch 2, **dadurch gekennzeichnet, dass** das Kühlmedium (13) pulsierend dem Wärmetauscher (19) zugeleitet wird.

4. Kühlsystem nach einem der Ansprüche 2 oder 3, **dadurch gekennzeichnet, dass** für den Übergang des flüssigen Kühlmediums (9) Mittel zwischen dem Behälter (11) und dem Wärmetauscher (19) angeordnet sind.

5. Kühlsystem nach einem der Ansprüche 2 bis 4, **dadurch gekennzeichnet, dass** als Kühlmittel CO₂ verwendet wird.

6. Kühlsystem nach einem der Ansprüche 1 bis 5, **dadurch gekennzeichnet, dass** im Schaltschrank (1) Verbindungsleitungen zur Umgebung des Schaltschranks (1) oder zu einer externen Kühlvorrichtung (5) bei Temperaturerhöhung verschliessbar ausgebildet sind.

7. Kühlsystem nach einem der Ansprüche 2 bis 6, **dadurch gekennzeichnet, dass** die Menge von in den Schaltschrank (1) eingeleiteten Kältemitteln in Abhängigkeit der Temperatur im Schaltschrank (1) durch das Ventil (15) geregelt wird.
